Europäisches Patentamt

European Patent Office

Office européen des brevets

(11) Veröffentlichungsnummer: **0 484 565 A1**

## EUROPÄISCHE PATENTANMELDUNG

(21) Anmeldenummer: **90121129.2**

(22) Anmeldetag: **05.11.90**

(51) Int. Cl.5: **H03K 17/94**, G01S 7/52

(43) Veröffentlichungstag der Anmeldung:
**13.05.92 Patentblatt 92/20**

(84) Benannte Vertragsstaaten:
**CH DE FR GB IT LI SE**

(71) Anmelder: **SIEMENS AKTIENGESELLSCHAFT**
**Wittelsbacherplatz 2**
**W-8000 München 2(DE)**

(72) Erfinder: **Forster, Alfred, Dipl.-Ing. (FH)**
**Nariskerstrasse 3**
**W-8460 Schwandorf(DE)**
Erfinder: **Schwarz, Robert, Dipl.-Ing. (FH)**
**Hammermühlstrasse 4**
**W-8451 Freudenberg(DE)**

(54) **Integrierte Selbststeuerung bei Ultraschall-Näherungsschaltern.**

(57) Der für den Betrieb des Ultraschall-Näherungs-schalters erforderliche Sendeimpuls wird üblicher-weise außerhalb in einer getrennten Auswerteelektro-nik erzeugt. Hierfür ist zusätzlicher Schaltungsauf-wand in Form von einer Analog- oder Digitalschal-tung oder eines Mikroprozessors notwendig. Die Er-zeugung des Sendeimpulses (24) wird erfindungsge-mäß bei Ultraschall-Näherungsschaltern, die einen integrierten Schaltkreis (6) mit einem Sendeoszillator (1) aufweisen, dadurch gelöst, daß auf dem integrier-ten Schaltkreis (6) zusätzliche Mittel zur Erzeugung eines Sendetaktes (4) vorgesehen werden. Über ein Steuersignal (9) ist es möglich, zwischen dem Be-trieb mit diesem Sendetakt (4) und einem von außen von der Auswerteelektronik zugeführten Sendetakt (3) zu wählen.

FIG 1

Die Erfindung betrifft einen Ultraschall-Näherungsschalter mit einem Sendeoszillator, dessen Sendefrequenz aufgrund eines ersten Sendetaktes periodisch für eine konstante Sendezeit auf eine Sendestufe aufgeschaltet wird.

Ultraschall-Näherungsschalter der obengenannten Art sind bereits bekannt (siehe DE 27 21 254). Üblicherweise stehen Ultraschall-Näherungsschalter mit einer Auswerteelektronik in Verbindung, die das Sende- und Empfangssignal des Ultraschall-Näherungsschalters auswertet. Bisher wurde der Sendetakt in der Auswerteelektronik erzeugt und dann dem Ultraschall-Näherungsschalter zugeführt. Für die Erzeugung des Sendetaktes war dabei zusätzlicher Schaltungsaufwand erforderlich, der in Form von Analog- oder Digitalschaltungen hardwaremäßig oder durch Software in Verbindung mit einem Mikroprozessor bestanden hat.

Der Erfindung liegt die Aufgabe zugrunde, die aus Auswerteelektronik und dem Ultraschall-Näherungsschalter bestehende Einheit der obengenannten Art zu vereinfachen und den Kostenaufwand zu reduzieren. Die Aufgabe wird dadurch gelöst, daß der Sendeoszillator Bestandteil eines integrierten Schaltkreises ist und daß der Schaltkreis einen ersten Eingang zur Aufnahme des ersten Sendetaktes, einen zweiten Eingang zur Aufnahme eines Steuersignals und interne Mittel zur Erzeugung eines zweiten Sendetaktes aufweist, wobei das Steuersignal eine wechselseitige Umschaltung zwischen interner und äußerer Taktung der Sendefrequenz ermöglicht. Diese Lösung bietet die Möglichkeit mit einer vereinfachten Auswerteelektronik auszukommen, die selbst keinen Sendetakt erzeugt. Stattdessen wird in diesem Fall auf einfache und kostensparende Weise mit Hilfe des integrierten Schaltkreises im Näherungsschalter selbst der erforderliche Sendetakt erzeugt. Eine besonders einfache Ausführung ist gegeben, wenn die Mittel zur Erzeugung des zweiten Sendetaktes eine Zählschaltung aufweisen, die Impulse der Sendefrequenz des Sendeoszillators zählen. Vorteilhafterweise weist die Zählschaltung mindestens einen Pausenzeitzähler und einen Sendezeitzähler auf. Um eine optimale Anpassung an die vorliegenden Umgebungsbedingungen zu erreichen erweist es sich als zweckmäßig, wenn die Zähler für die Sende- und die Zykluszeit des Sendetaktes getrennt einstellbar sind. Ist neben einem ersten Umschalter zur Umschaltung zwischen interner und äußerer Taktung ein zweiter Umschalter vorgesehen, über den je nach Taktzustand zwei unterschiedliche Signale einem Ausgang des integrierten Schaltkreises zuführbar sind, so können auf diese Art und Weise z. B. den Taktzustand kennzeichnende Größen an die Auswerteelektronik weitergegeben werden. Es ist zweckmäßig, wenn am Ausgang bei interner Taktung der zweite Sendetakt ansteht. Weist der integrierte Schaltkreis eine Einrichtung auf, mit deren Hilfe ein die umgebende Lufttemperatur repräsentierender Temperaturimpuls erzeugbar ist, so kann mit diesem Temperaturimpuls die durch die Temperatur bedingte Beeinflussung der Echolaufzeit in der Auswerteelektronik kompensiert werden. Es erweist sich als zweckmäßig, wenn am Ausgang bei äußerer Taktung der Temperaturimpuls ansteht.

In der Zeichnung ist ein Ausführungsbeispiel der Erfindung dargestellt, das im folgenden näher beschrieben ist. Es zeigen:

FIG 1 ein Blockschaltbild eines integrierten Schaltkreises mit wesentlichen zur Erfindung gehörigen Komponenten,

FIG 2 ein Impulsdiagramm für äußere Taktung,

FIG 3 ein Impulsdiagramm für innere Taktung.

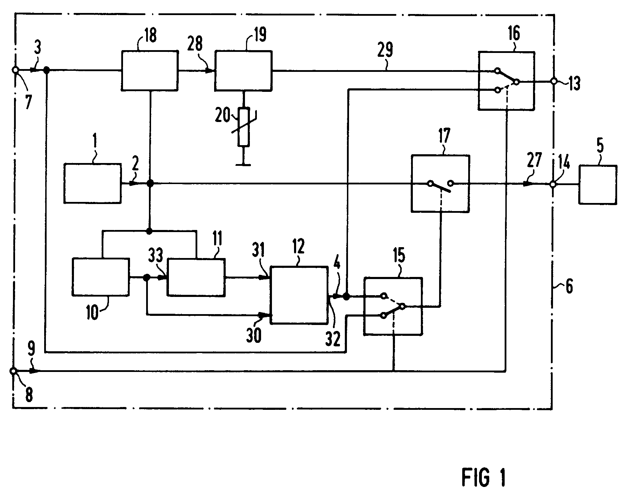

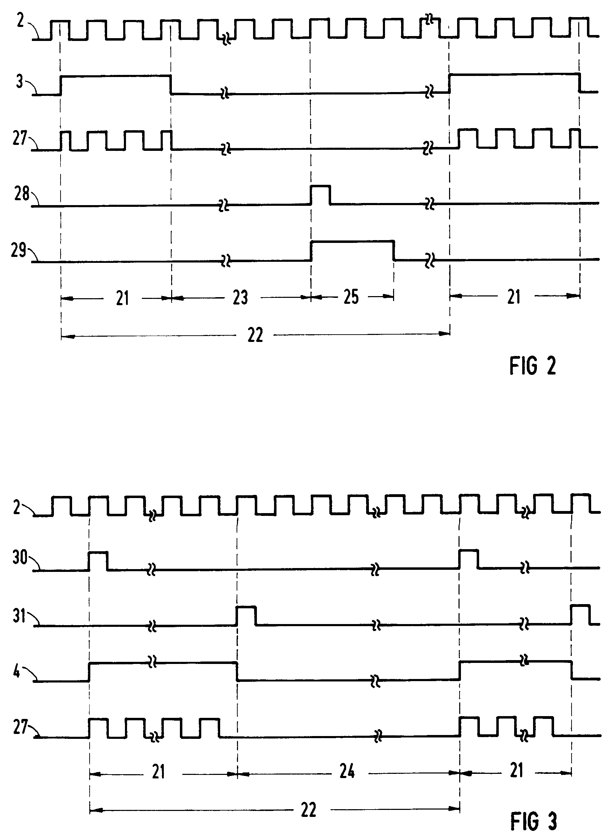

In Figur 1 ist ein integrierter Schaltkreis 6 mit den wesentlichen zur Erfindung gehörigen Komponenten dargestellt. Der Schaltkreis 6 weist zwei Eingänge 7, 8 und zwei Ausgänge 13, 14 auf. Er umfaßt einen Sendeoszillator 1, der eine Sendefrequenz 2 erzeugt, zwei Umschalter 15, 16, einen Schalter 17, sowie eine Einrichtung zur Erfassung der Lufttemperatur und Mittel, mit denen intern ein Sendetakt 4 erzeugt wird. Letztere umfassen einen Pausenzeitzähler 10, einen Sendezeitzähler 11 und ein Flip-Flop 12. Die Einrichtung zur Temperaturerfassung ist hier durch einen Pausenzeitzähler 18 und ein Monoflop 19 in Verbindung mit einem Heißleiter 20 verwirklicht. Der Eingang 7 des integrierten Schaltkreises 6 steht einerseits mit dem Umschalter 15 und andererseits mit dem Pausenzeitzähler 18 elektrisch in Verbindung. Der andere Eingang 8 ist an die Steuereingänge der Umschalter 15 und 16 angeschlossen. Der Schalter 17 ist zwischen den Oszillator 1 und den Ausgang 14 geschaltet, an dem von außen eine Sendestufe 5 anschließbar ist. Durch Anlegen eines entsprechenden Steuerimpulses 9 am Eingang 8 des Schaltkreises 6 kann wahlweise eine äußere oder innere Taktung vorgenommen werden. Bei äußerer Taktung ist der Umschalter 15 derart geschaltet, daß ein dem Eingang 7 von außen zugeführter Sendetakt 3 an den Schalter 17 weitergeleitet wird, so daß dieser die vom Sendeoszillator 1 zugeführte Sendefrequenz 2 für entsprechende Taktzeiten des Sendetaktes 3 auf die Sendestufe 5 aufschaltet. Vom Ausgang des Schalters 17 wird demzufolge ein Sendeimpuls 27 gemäß Figur 2 an die Sendestufe 5 übertragen. Der Figur 1 ist weiterhin zu entnehmen, daß im Zustand der äußeren Taktung der Umschalter 16 derart geschaltet ist, daß ein von der Einrichtung zur Temperaturerfassung gelieferter Temperaturimpuls 29 gemäß Figur 2 an den Ausgang 13 weitergeleitet wird. Die Synchronisation des Temperaturimpulses 29 erfolgt über den Pausenzeitzähler 18, der mit der abfallenden Flanke der Sendezeit 21 des Sendetaktes 3 anläuft. Der Pausenzeitzähler 18 zählt eine vorgegebene Anzahl von Impulsen der ihm vom Sendeoszillator 1 zugeführten Sendefrequenz 2. Nach Ablauf einer Pausenzeit 23 gibt der Pausenzeitzähler 18 einen Triggerimpuls 28 ab, durch den ein Monoflop 19 gestartet wird. Das Monoflop 19 gibt aufgrund einer entsprechenden Beschaltung, z. B. bei Einsatz eines Heißleiters 20 einen entsprechenden weiten Temperaturimpuls 29 mit der Impulslänge 25 am Ausgang ab. Von hier aus wird der Temperaturimpuls 29 an den Ausgang 13 des Schaltkreises 6 über den auf Durchgang geschalteten Umschalter 16 weitergeleitet.

Die Umschaltung auf interne Taktung wird über das Steuersignal 9 am Eingang 8 bewirkt, was einen Zustandswechsel der beiden Umschalter 15 und 16 zur Folge hat. Nun wird ein zweiter Sendetakt 4, der mit dem Pausenzeitzähler 10, dem Sendezeitzähler 11 und dem Flip-Flop 12 erzeugt wird, über den Umschalter 15 dem Schalter 17 zugeführt. Üblicherweise wird der Sendetakt 4 dem Sendetakt 3 entsprechen, so daß in beiden Fällen der gleiche Sendeimpuls 27 gemäß Figur 2 und 3 am Ausgang 14 des Schaltkreises 6 ansteht. Die Erzeugung des Sendetaktes 4 bei interner Taktung erfolgt ausgehend vom freilaufenden Sendeoszillator 1, dessen Sendefrequenz dem Eingang des Pausenzeitzählers 10 und am Eingang des Sendezeitzählers 11 zugeleitet wird. Der Pausenzeitzähler 10 für die Pausenzeit 21 gemäß Figur 3 ist freilaufend. Nach der Pausenzeit 24 gemäß Figur 3 wird bei Erreichen des eingestellten Zählerstandes des Pausenzeitzählers 10 ein Setimpuls 30 an das Flip-Flop 12 gegeben, womit der Q-Ausgang 32 des Flip-Flops 12 aktiviert wird. Gleichzeitig wird über einen Starteingang 33 der Sendezeitzähler 11 getriggert, der ebenfalls vom Sendeoszillator 1 getaktet wird. Nach Ablauf der Sendezeit 21 gemäß Figur 3 führt ein Resetimpuls 31 am Flip-Flop 12 zum Abschalten seines Q-Ausgangs 32. Der auf diese Weise erzeugt Sendetakt 4 gelangt über den Umschalter 16 zum Ausgang 13 und wird zur Synchronisation einer externen Auswerteschaltung herangezogen. Weiterhin könnte als Alternative ein dritter Umschalter vorgesehen werden, der bei äußerer Taktung den Eingang 7 mit dem Zähler 18 verbindet. Bei Umschaltung auf interne Taktung müßte allerdings der interne Sendetakt 4 über diesen dritten Umschalter auf den Zähler 18 aufgeschaltat werden, so daß es nun möglich ist, den Temperaturimpuls 29 auch in diesem Fall synchronisiert zu erzeugen. Allerdings müßte in diesem Fall ein weiterer Ausgang des Schaltkreises 6 zur Verfügung gestellt werden, über den der Temperaturimpuls 29 z. B. von einer Auswerteelektronik übernommen werden kann.

**Patentansprüche**

1. Ultraschall-Näherungsschalter mit einem Sendeoszillator (1), dessen Sendefrequenz (2) aufgrund eines ersten Sendetaktes (3) periodisch für eine konstante Sendezeit (21) auf eine Sendestufe (5) aufgeschaltet wird, **dadurch gekennzeichnet**, daß der Sendeoszillator (1) Bestandteil eines integrierten Schaltkreises (6) ist und daß der Schaltkreis (6) einen ersten Eingang (7) zur Aufnahme des ersten Sendetaktes (3), einen zweiten Eingang (8) zur Aufnahme eines Steuersignals (9) und interne Mittel (10, 11, 12) zur Erzeugung eines zweiten Sendetaktes (4) aufweist, wobei das Steuersignal (9) eine wechselseitige Umschaltung zwischen interner und äußerer Taktung der Sendefrequenz (2) ermöglicht.

2. Ultraschall-Näherungsschalter nach Anspruch 1, **dadurch gekennzeichnet**, daß die Mittel zur Erzeugung des zweiten Sendetaktes (4) eine Zählschaltung (10, 11) aufweisen, die Impulse der Sendefrequenz (2) des Sendeoszillators (1) zählt.

3. Ultraschall-Näherungsschalter nach Anspruch 1 oder 2, **dadurch gekennzeichnet**, daß die Zählschaltung mindestens einen Pausenzeitzähler (10) und einen Sendezeitzähler (11) aufweist.

4. Ultraschall-Näherungsschalter nach Anspruch 1, 2 oder 3, **dadurch gekennzeichnet**, daß die Zähler (10, 11) für die Sende- (21) und die Zykluszeit (22) des Sendetaktes (4) getrennt einstellbar sind.

5. Ultraschall-Näherungsschalter nach einem der obengenannten Ansprüche, **dadurch gekennzeichnet**, daß neben einem ersten Umschalter (15) zur Umschaltung zwischen interner und äußerer Taktung ein zweiter Umschalter (16) vorgesehen ist, über den je nach Taktzustand zwei unterschiedliche Signale (4, 29) einem ersten Ausgang (13) des integrierten Schaltkreises (6) zuführbar sind.

6. Ultraschall-Näherungsschalter nach Anspruch 5, **dadurch gekennzeichnet**, daß am ersten Ausgang (13) bei interner Taktung der Sendetakt (4) ansteht.

7. Ultraschall-Näherungsschalter nach einem der obengenannten Ansprüche, **dadurch gekennzeichnet**, daß der integrierte Schaltkreis (6) eine Einrichtung (18, 19, 20) aufweist, mit deren Hilfe ein die umgebende Lufttemperatur repräsentierender Temperaturimpuls (29) erzeugbar ist.

8. Ultraschall-Näherungsschalter nach Anspruch 6 oder 7, **dadurch gekennzeichnet**, daß am Ausgang (13) bei äußerer Taktung der Temperaturimpuls (29) ansteht.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | WO-A-8000497 (HOLLANDSE SIGNAAL APPARATEN) <br> * Seite 2, Zeile 28 - Seite 5, Zeile 10; Figuren 1a, 1b, 2-3 * <br> ----- | 1 | H03K17/94 <br> G01S7/52 |

**RECHERCHIERTE SACHGEBIETE (Int. Cl.5)**

H03K
G01S
G08B

**Der vorliegende Recherchenbericht wurde für alle Patentansprüche erstellt**

| Recherchenort | Abschlußdatum der Recherche | Prüfer |
|---|---|---|
| DEN HAAG | 05 JULI 1991 | AUGARDE E.P.G.T. |